# EUROPÄISCHE PATENTANMELDUNG

(11) **EP 3 361 032 A1**
(43) Veröffentlichungstag der Anmeldung: **15.08.2018**
(21) Anmeldenummer: 18156611.8
(22) Anmeldetag: 14.02.2018
(51) Int. Cl.: E05F 15/46

(54) **VERFAHREN UND VORRICHTUNG ZUM STEUERN EINER TÜR, VORZUGSWEISE SCHIEBETÜR**

(30) Priorität: 14.02.2017 AT 501182017
(71) Anmelder: Liberda, Victor, 1010 Wien (AT); Liberda, Rudolf, 1090 Wien (AT)
(72) Erfinder: Liberda, Victor, 1010 Wien (AT); Liberda, Rudolf, 1090 Wien (AT)
(74) Vertreter: Patentanwaltskanzlei Matschnig & Forsthuber OG

(57) **Zusammenfassung**

Zum Steuern einer von einem Motor (14) angetriebenen Tür (10), insbesondere Schiebetür, werden die Kapazitäten zumindest zweier an einer Stirnfläche (19) eines Türblatts (12) der Tür angeordneten kapazitiven Sensorelektroden (21) unabhängig voneinander gegen ein gemeinsames Referenzpotential, vorzugsweise Massepotential, ermittelt. Wenn eine Kapazitätsänderung an zumindest einer der Sensorelektroden im Vergleich zu zumindest einer weiteren Sensorelektrode ermittelt wird, wird ein Signal zum Anhalten des Motors generiert.

## Beschreibung

Die Erfindung betrifft ein Verfahren zum Steuern einer von einem Motor angetriebenen Tür, insbesondere Schiebtür, sowie eine Vorrichtung zum Steuern einer derartigen Tür.

Die hier betrachtete Erfindung eignet sich grundsätzlich für motorgetriebene Türen aller Art, und vorzugsweise Schiebetüren; daneben kommen z.B. auch Rolltore, Sektionaltore, Hubtore, gegebenenfalls auch Drehtüren, in Betracht. Motorgetriebene Türen sind weit verbreitet und finden in vielen Bereichen Anwendung. Beispielsweise werden von Kraftfahrzeugen benutzbare Toranlagen für Grundstücke häufig mit motorisierten Türen ausgeführt, insbesondere bei besonders groß dimensionierten Toranlagen, wie zum Beispiel Schiebetüren oder Schiebetoren für Garagen, Passagen in Einkaufszentren oder Flugzeughangars, werden in der Regel die beweglichen Teile der Türen/Tore von einem Motor zum Öffnen und Schließen angetrieben.

Zweckmäßiger Weise verfügen diese Anlagen über Mittel zum Erkennen von Hindernissen im Verschiebeweg der motorisierten Schiebtür, wobei das Vorhandensein eines Hindernisses im Verschiebweg zu einem sofortigen Anhalten und ggf. zu einem erneuten, teilweisen oder vollständigen, Öffnen der Schiebetür führt. Herkömmlicher Weise sind die genannten Mittel zum berührungslosen Erkennen von Hindernissen im Verschiebweg der motorisierten Schiebetür als optische Sicherungselemente wie Lichtschranken oder Lichtgitter ausgeführt, sodass auch nur das Hindurchtreten eines Hindernisses, beispielsweise einer Person, zu einem Stör- oder Haltesignal für den Antrieb führt, auch wenn die Person weit entfernt von der Türkante den Verschiebeweg kreuzt und daher von der Schließbewegung der Schiebetür gänzlich ungefährdet ist. Bei großen Toranlagen, wie den genannten Hangartoren führt dies unter Umständen dazu, dass die Tore im normalen Betrieb praktisch nicht mehr vollständig geschlossen sind, da während des Schließens, welches aufgrund der Größe und des Gewichts der Schiebetür eine gewisse Zeit in Anspruch nimmt, beinahe zwangsläufig Personen den Verschiebeweg kreuzen und eine herkömmlich, beispielsweise mit Lichtschranken, überwachte Schiebetür bei jedem Durchtritt einer Person oder eines Fahrzeugs stoppt und wieder in eine geöffnete Position verfährt.

Der vorliegenden Erfindung liegt daher die Aufgabe zugrunde, eine Steuerung einer motorisierten (Schiebe)Tür zu schaffen, bei der der kurze Durchtritt von Personen, Fahrzeugen oder kleinen Gegenständen nicht automatisch zu einem Anhalten des Motors führt, sondern bei entsprechend ausreichendem Abstand der Person, des Fahrzeugs oder ähnlichem die Schließbewegung bzw. der Motor zum Schließen und Öffnen der Tür nicht angehalten wird, aber dennoch eine berührungslose Hinderniserkennung gewährleistet ist. Prinzipiell bieten sich hierfür Verfahren mit kapazitiver Detektion von Hindernissen an, da diese - anders als Lichtschranken - nur einen gewissen Bereich um den Sensor erfassen; jedoch sind kapazitive Verfahren in höchstem Maße anfällig für Umwelteinflüsse wie Feuchtigkeit, Staub, Verschmutzungen und ähnliches, sodass sie bisher nicht kommerziell umgesetzt werden konnten.

Zur Lösung der soeben dargelegten Aufgabe zeichnet sich das erfindungsgemäße Verfahren dadurch aus, dass die Kapazitäten zumindest zweier an einer Türkante der Schiebetür angeordneter kapazitiver Sensorelektroden gegen Massepotential bzw. ein gemeinsames Referenzpotential (z.B. jenes des Türblatts oder des Türrahmens) bestimmt werden und bei Feststellen eines Unterschiedes zwischen der Kapazität von zumindest einer der Sensorelektroden im Vergleich zu zumindest einer weiteren Sensorelektrode ein Signal zum Anhalten des Motors, z.B. in einer Rechen- oder Steuerungseinheit, generiert wird. Beispielsweise ist es möglich, dass in schneller Reihenfolge die Kapazitäten je zweier Sensorelektroden vorzugsweise durch Subtraktion miteinander verglichen werden, beispielsweise mehrmals pro Sekunde, bevorzugt 50mal bis 500mal pro Sekunde. Zum einen wird durch die Verwendung von kapazitiven Sensorelektroden der bereits geschilderte Nachteil von Lichtschranken eliminiert, da nur ein Hindernis in der Nähe der Sensorelektroden zu einer Detektion führt. Dadurch jedoch, dass nicht nur eine, sondern mehrere Sensorelektroden, also zumindest zwei Sensorelektroden an der Türkante vorgesehen sind, und dadurch, dass die Kapazitäten dieser Sensorelektroden unabhängig voneinander gegen Masse bestimmt werden, kann die Anwesenheit eines Hindernisses bzw. einer Person in der Nähe der Türkante erkannt werden, da nur Kapazitätsunterschiede an zumindest zwei Sensorelektroden zum Generieren eines Haltesignals führen. Nähert sich die Tür jedoch ihrer geschlossenen Stellung, werden die Kapazitäten aller Sensorelektroden durch das Einlaufprofil gleichermaßen verändert und kein Haltesignal wird generiert. Gleiches gilt für Kapazitätsänderungen an allen Sensorelektroden durch Umwelteinflüsse, wie z.B. durch Änderungen der Luftfeuchtigkeit: die Kapazitäten aller Sensorelektroden ändern sich gleichlaufend und es wird kein Haltesignal generiert. Durch das erfindungsgemäße Verfahren gelingt es somit, eine motorisierte Schiebetür nur dann anzuhalten, wenn sich tatsächlich ein Hindernis im Gefahrenbereich vor der Türkante befindet, sodass auch große Schiebetüren weiterhin in die Schließposition verfahren werden können, wenn sich auch potentielle Hindernisse in gewisser Entfernung zur Türkante im Verschiebeweg befinden. Solange es nicht zu einer gefährlichen Annäherung des Hindernisses an die Türkante kommt, wird die Tür weiter geschlossen, sodass sich insgesamt die Wahrscheinlichkeit erhöht, automatische Türen auch in einem stärker frequentierten Arbeitsumfeld ordnungsgemäß verschlossen vorzufinden.

In gleicher Weise sieht die Erfindung eine Vorrichtung zum Steuern einer von einem Motor angetriebenen Schiebetür vor, mit zumindest zwei kapazitiven Sensorelektroden an einer Türkante der Schiebetür und mit Mitteln (Messeinrichtungen) zum Bestimmen der Potentiale der zumindest zwei kapazitiven Sensorelektroden unabhängig voneinander gegen Masse; und es sind weiters Einrichtungen (z.B. ein Signalgeber oder ein Mikroprozessor) vorgesehen, um bei Feststellen einer Kapazitätsänderung an zumindest einer der Sensorelektroden im Vergleich zu zumindest einer weiteren Sensorelektrode ein Signal zum Anhalten des Motors zu generieren; dieses Signal wird dann an eine Motorsteuerung der motorisierten Tür geführt. Die Vorteile dieser Vorrichtung und ihre Weiterbildungen entsprechen jenen, die weiteroben im Zusammenhang mit dem erfindungsgemäßen Verfahren diskutiert wurden.

Gemäß einer bevorzugten Ausführungsform der Erfindung können die kapazitiven Sensorelektroden mit Wechselstrom, bevorzugt bei einer Frequenz von 150 kHz bis 400 kHz, insbesondere 200 kHz bis 300 kHz, betrieben werden. Jedoch sind im Allgemeinen die Frquenzen in einem weiten Bereich zwischen 10 kHz und ca. 5 MHz wählbar. Bei diesen Frequenzen kann eine genügend große Zahl an Messwerten erzeugt werden, die von der Steuerungseinheit zu einem gut brauchbaren Mittelwert verdichtet werden, und damit wird die bestmögliche Balance zwischen Ausdehnung des sensitiven Bereichs und geringer Störungsanfälligkeit der Elektroden erreicht.

Günstiger Weise kann das erfindungsgemäße Verfahren derart implementiert sein, dass die kapazitiven Sensorelektroden an der Türkante übereinander als voneinander beabstandete Streifen aus elektrisch leitendem Material, vorzugsweise Metall, auf einer Isolierschicht, z.B. aus einem Kunststoffmaterial, angeordnet werden. Die Isolierschicht muss hinsichtlich ihrer relativen Permittivität stabil sein und darf daher kein Wasser aufnehmen; niedrige Werte der Permittivitätszahl sind erwünscht, um das Auftreten von störenden Streukapazitäten gering zu halten. Die Permittivitätszahl soll daher maximal 6 betragen, vorzugsweise jedoch 1 bis 4, vorzugsweise maximal 3. Eine Isolierschicht aus Polyäthylen oder Polytetrafluoräthylen ist günstig herzustellen und sorgt für eine zuverlässige Isolierung der Elektroden gegenüber der Türkante. Die Isolierschicht kann auch aus einem Harz-basierten Material bestehen, wie z.B. FR4 oder einem anderen Epoxidharz mit Glasgewebe-Einlage.

Gemäß einer günstigen Ausgestaltung der Erfindung kann das erfindungsgemäße Verfahren dahingehend weitergebildet sein, dass die kapazitiven Sensorelektroden gegenüber dem Türblatt (bzw. genauer dem Körper des Türblatts) durch zumindest eine gesteuerte Schirmelektrode räumlich und elektrisch getrennt werden. Beispielsweise können sie an ihrer der Türkante zugewandten Seite von einer durch eine Isolierung getrennten, gesteuerten Schirmelektrode umfasst sein, die z.B. mit U-förmigem Querschnitt gestaltet ist. Zusätzlich können an den Seiten der U-Form, vorzugsweise von der Basis des U abstehende Ansätze vorgesehen sein; die Ansätze sind vorzugsweise symmetrisch angeordnet und ergeben zusammen mit der U-Form die Breite des Türblattes. Alternativ kann die Schirmelektrode flach sein, mit einer Breite die gleich oder geringer ist als die Breite des Türblattes, in deren Türkante die Sensorelektroden integriert sind. Dies bedeutet, dass die Sensorelektroden von der Schirmelektrode im Wesentlichen hinten, d.h. an der der Tür zugewandten Seite oder an den Seiten und hinten, d.h. an der der Tür zugewandten Seite umgeben werden.

Die Schirmelektrode kann günstiger Weise mit derselben Phase und Amplitude betrieben werden wie die Sensorelektroden, vorzugsweise von derselben Quelle. Die gesteuerte Schirmelektrode sorgt einerseits dafür, dass die Kapazitäten der Sensorelektroden von der der Tür zugewandten Seite und gegebenenfalls von den Seiten, d.h. von jenen Seiten, die für die Erfassung von eventuellen Hindernissen irrelevant sind, viel weniger beeinflussbar sind, sodass Fehldetektionen verhindert werden können. Andererseits gelingt durch eine geeignet gewählte Geometrie der Schirmelektrode und insbesondere deren seitlich abstehender Ansätze eine Formung des Feldlinienmusters der Sensorelektroden, sodass insgesamt der Bereich der Erfassung von Hindernissen durch die Sensorelektroden vergrößert bzw. eingestellt werden kann.

Ein Sensor mit einer so ausgebildeten Schirmelektrode wirkt vorteilhafterweise in der Verlängerung der Türblattebene. Um mit dem Sensor auch seitlich von der Türblattebene befindliche Hindernisse erfassen zu können, kann eine flache Schirmelektrode gewählt werden, die gleich breit ist wie der Sensor. Um das seitliche Feld stärker auszudehnen, kann die Sensorelektrode flach oder leicht gekrümmt ausgebildet werden; zusätzlich kann sie mit seitlichen, in Richtung zur Schirmelektrode abstehenden kurzen Schenkeln, vorzugsweise 1 bis 5 mm lang, versehen sein.

Die Kapazitätsmessung erfolgt gegen ein gemeinsames Referenzpotential, in der Regel gegenüber Erde, und ist daher, je nachdem ob der Sensor an einem Türblatt aus elektrisch leitendem oder aus nicht leitendem Material montiert ist, unterschiedlich empfindlich. Türblätter aus Metall oder anderem leitenden Material verringern häufig die Sensitivität der Messung. Um diesen Effekt auszugleichen, ist es häufig günstig, wenn die Messeinrichtung über ein Element aus leitendem Material, vorzugsweise über einen mit Abstand zu den Sensorelektroden isoliert zu diesen verlegten Blechstreifen, gut kapazitiv mit Erde gekoppelt ist. Dieses Kopplungselement ist bevorzugt an einer anderen Türkante (z.B. der oberen und/oder der unteren) als der Türkante der Sensorelektroden angeordnet, und erbringt durch die kapazitive Kopplung des Türblatts an das Massepotential eine Stabilisierung der Kapazitätsmessung. Weiters ist es von Vorteil, wenn die gesteuerte Schirmelektrode von leitenden Türen gut isoliert sein und mit größerem Abstand als bei nicht leitenden Türblättern, vorzugsweise größer als 15mm bzw. in einem Bereich von 10 bis 20 mm (gegebenenfalls bis zu 50mm) angebracht werden. Bei nicht-leitenden Türblättern dagegen sind in der Regel geringere Abstände möglich, typischer Weise unter 10 mm, beispielsweise bei 4 mm ± 1 mm.

Die vorliegende Erfindung ist bevorzugt dahingehend weitergebildet, dass eine Steuerungseinheit eingerichtet ist, das Signal zum Anhalten des Motors zu generieren, sowie vorteilhafterweise die Kapazitätsänderung durch Wasser von der durch andere Hindernisse zu unterscheiden und kabellos an eine Steuereinheit für den Motor zu übertragen.

Eine bevorzugte Variante der vorliegenden Erfindung sieht vor, dass die Komponenten zum Steuern der motorisierten Schiebetür, insbesondere die Sensorelektroden, die Schirmelektroden und die Isolierschicht an einem Trägerelement angeordnet sind; auf dem Trägerelement, das auf einer Türkante befestigbar ist, sind somit die Sensorelektroden sowie gegebenenfalls die Schirmelektrode und weitere Komponenten angeordnet. Dies gestattet es, die erfindungsgemäße Detektionsvorrichtung vorzufertigen und ohne großen Aufwand an einer bestehenden Tür, insbesondere Schiebetür, zu montieren. Dadurch wird ein Nachrüsten mit der erfindungsgemäßen Vorrichtung zur Durchführung des erfindungsgemäßen Verfahrens ermöglicht.

Um die Empfindlichkeit gegenüber äußeren Störungen zu verringern (elektromagnetische Verträglichkeit, EMV) kann es zudem günstig sein, wenn die Sensorelektroden über die gesamte Höhe der Stirnfläche verlaufen. Jede der Sensorelektroden kann hierbei eine entlang der Höhe und in von den anderen Sensorelektroden unterschiedlicher Weise variierende Breite aufweisen. Alternativ oder in Kombination dazu können sich in jeder der Sensorelektroden schmale Bereiche (d.h. Bereiche mit vernachlässigbarer Breite) mit zumindest zwei Elektrodenflächen abwechseln. Hierbei bedeutet "Höhe" die Koordinate der Längsrichtung der Türkante, ungeachtet der allfälligen tatsächlichen Ausrichtung der Türe; zumeist ist die Türkante freilich entlang der Vertikalen orientiert.

In einer Ausführungsform mit über die gesamte Höhe oder zumindest einen Höhenbereich verlaufenden Sensorelektroden kann es zudem günstig sein, wenn an zumindest einem Endbereich der Stirnfläche die Sensorelektroden zueinander gleich breit sind; dadurch kann ein Kürzen der Sensorelektroden ermöglicht werden, nämlich in dem Endbereich (gegebenenfalls auch an beiden Endbereichen) und um eine Länge der Kürzung bis zu einem bestimmten maximalen Kürzungsbetrag. Hierdurch kann die Anpassung einer (z.B. mit einem vorgegebenen Längenmaß vorgefertigten) Sensoreinrichtung an das aktuell gegebene Höhenmaß der Türkante erleichtert werden.

In einer vorteilhaften Ausgestaltung der Erfindung beinhaltet das Steuersystem seitens des Türblatts eine (nur) drahtlos verbundene Sensoreinrichtung. Diese ist mit der Steuerungseinheit über eine drahtlose Schnittstelle verbunden, über welche von der Sensoreinrichtung ermittelte Werte der Kapazitäten und/oder Kapazitätsdifferenzen drahtlos übermittelt werden. Zudem kann die Energieversorgung der Sensoreinrichtung über die drahtlose Schnittstelle erfolgen, beispielsweise über ein Funk- oder Infrarot-Signal. Die Energieversorgung kann auch über eine induktive Ankopplung im geschlossenen Zustand der Tür erfolgen.

Um den Energieverbrauch seitens der Sensoreinrichtung, die die kapazitiven Sensorelektroden aufseiten des Türblatts umfasst, zu verringern und insbesondere im Fall einer drahtlosen Sensoreinrichtung die Lebenszeit der dort vorgesehenen Energiespeicher (Batterien oder Akkus) zu erhöhen, ist es günstig, die die Sensoreinrichtung (nur) für die Dauer einer Türbewegung der Tür zu aktivieren. Zu diesem Zweck können Signale - z.B. Steuersignale zur Aktivitätssteuerung - zu zweckmäßigen Zeitpunkten, insbesondere zu Beginn und am Ende einer Türbewegung, an die Sensoreinrichtung gesendet werden (gegebenenfalls ebenfalls drahtlos), um die Sensoreinrichtung für die Dauer der Türbewegung zu aktivieren; danach wird die Sensoreinrichtung wieder deaktiviert.

Die Erfindung wird im Folgenden anhand einiger Ausführungsbeispiele näher erläutert, die in den beigefügten Zeichnungen dargestellt sind und in beispielhafter Weise zur Erläuterung der Erfindung dienen sollen, ohne die Erfindung einzuschränken. Die Zeichnungen zeigen in schematischer Form:
- Fig. 1: eine perspektivische Ansicht einer Schiebetür mit einer ersten Ausführungsform des erfindungsgemäßen Steuersystems;
- Fig. 2: eine Frontalansicht der Türkante des Türblatts der Schiebetür der Fig. 1 und insbesondere der Sensoreinrichtung des Steuersystems;
- Fig. 3: eine Seitenansicht der Sensoreinrichtung der Fig. 2;
- Fig. 3a: ein vergrößertes Detail der Sensoreinrichtung gemäß dem Ausschnitt A der Fig. 3;
- Fig. 4: eine vergrößerte Aufsicht auf die Türkante und die Sensoreinrichtung;
- Fig. 4a: die Komponenten der Sensoreinrichtung in Aufsicht in explodierter Darstellung;
- Fig. 5: die Komponenten einer Variante der Sensoreinrichtung in Aufsicht in explodierter Darstellung;
- Fig. 6: eine Schnittansicht der Sensoreinrichtung, in der der Verlauf eine typischen Feldlinienverteilung gezeigt ist;
- Fig. 7: eine Schnittansicht einer weiteren Ausführungsform mit einer Schirmelektrode mit Vorsprüngen;
- Fig. 8a-8k: weitere Ausgestaltungen der Elektroden der Sensoreinrichtung in gleichartigen Schnittansichten;
- Fig. 9: ein Blockschaltbild des Steuersystems der ersten Ausführungsform;
- Fig. 10: ein Blockschaltbild eines Steuersystems mit kabelloser Anbindung der Sensoreinrichtung;
- Fig. 11: ein Blockschaltbild einer Variante mit mehreren Gruppen von Sensorelektroden;
- Fig. 12: eine Frontalansicht einer weiteren Ausführungsform einer Sensoreinrichtung, die zudem ein Kürzen erlaubt;
- Fig. 13: eine Seitenansicht der Sensoreinrichtung der Fig. 12;
- Fig. 14: eine Aufsicht auf die Sensoreinrichtung der Fig. 12; und
- Fig. 15a-15e: weitere Ausgestaltungen von Elektrodenanordnungen auf der Frontfläche, jeweils in Frontalansicht.

Selbstverständlich ist die gegenständliche Erfindung nicht auf die gezeigten Ausführungsbeispiele beschränkt, sondern umfasst auch vielerlei Abwandlungen und Ausgestaltungen innerhalb des Bereichs der untenstehenden Ansprüche.

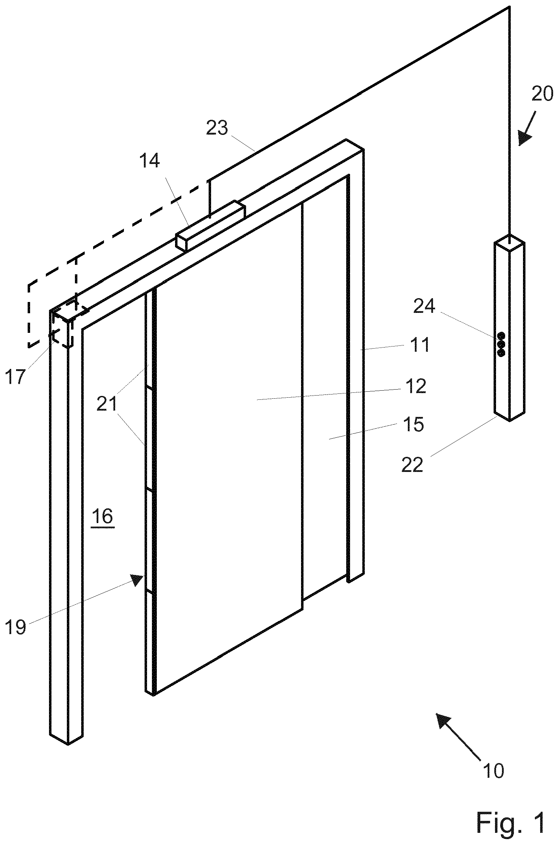

In Fig. 1 ist eine Schiebetür 10 gezeigt, die in einer Rahmenkonstruktion 11 ein darin verfahrbares, aufrecht stehendes Türblatt 12 aufweist, mit einem Motor 14 zum Antrieb der Bewegung des Türblatts 12 in einer horizontalen Richtung. Der Antrieb der Tür durch den Motor 14 erfolgt nach an sich bekannter Art, beispielsweise durch einen Linear- oder Zahnriemenantrieb. Rückseitig des Türblattes 12 umgibt der Rahmen 11 der Schiebetür dieses Ausführungsbeispiels eine Blindfläche 15, die im geschlossenen Zustand der Tür gemeinsam mit dem Türblatt den vom Rahmen umgebenen Türbereich verschließt und im geöffneten Zustand der Tür von dem Türblatt verdeckt wird, wobei die eigentliche Türöffnung 16 freigegeben wird.

Zum Ansteuern und Kontrollieren der Bewegung des Türblatts 12 ist die Tür 10 mit einem Steuersystem 20 ausgestattet. Das Steuersystem 20 umfasst eine Sensoreinrichtung 21, die an einer Stirnseite 19 des Türblatts 12 angeordnet ist. Unter Stirnseite wird hierbei jene Fläche oder Teilfläche des Türblatts verstanden, die bei einer schließenden Bewegung der Tür sich als Frontfläche voranbewegt, somit hierbei einen vordersten Flächenbereich des Türblatts bildet; im gezeigten Ausführungsbeispiel ist die Stirnseite 19 die sogenannte Türkante, nämlich die (hier vertikal orientierte) Schmalseite zwischen den beiden Türblatt-Flächen, die nach außen bzw. innen gerichtet sind. Die auf der Stirnseite 19 befindliche Sensoreinrichtung 21 umfasst zumindest zwei Sensorelektroden 31, im gezeigten Beispiel vier Sensorelektroden.

Zu dem Steuersystem 20 gehört auch eine Steuerungseinheit 22, die von der Tür 10 gesondert angeordnet sein kann (wie in Fig. 1 angedeutet) oder in einem Abschnitt des Rahmens 11 untergebracht sein kann. Die Steuerungseinheit 22 ist mit dem Motor 14 und der Sensoreinrichtung 21 über elektrische Leitungen 23 verbunden, z. B. im Überkopfbereich im Türrahmen oder außerhalb desselben geführt. Die Steuerungseinheit 22 weist ein Bedienpaneel 24 mit Bedienelementen auf, über die ein Benutzer das Öffnen und Schließen der Tür steuern kann. Beim Schließvorgang wird mithilfe der Sensoreinrichtung 21 überwacht, ob sich ein Hindernis in der Türöffnung befindet, wie z.B. eine Person, ein Körperteil (z. B. ein Finger) oder ein Haustier, denen infolge der Schließbewegung Schaden zugefügt werden könnte. Während der Öffnungsbewegungen kann die Sensoreinrichtung passiv bleiben; stattdessen kann gegebenenfalls eine zweite Sensoreinrichtung an der gegenüberliegenden Türkante montiert sein, um eventuelle Gefahrenstellen bei der Öffnungsbewegung abzusichern, wobei hierbei das zur Sensoreinrichtung der Türkante der Frontfläche der Schließbewegung *mutatis mutandis* gilt.

Alternativ können die Steuerungseinheit 22 und die Sensoreinrichtung 21 durch kabellose Verbindungen miteinander verbunden sein. Durch diese Maßnahme kann vermieden werden, dass zwischen Türrahmen und Türblatt Verbindungskabel oder ähnliche Komponenten vorgesehen werden müssen, die durch die Bewegung rasch verschleißen können. In diesem Fall kann die elektrische Versorgung der elektrischen Komponenten der Sensoreinrichtung 21 über eine Gegenstation 17 erfolgen, die in dem Türrahmen untergebracht ist, beispielsweise in einer oberen Ecke des Türrahmens, vorzugsweise am Rand der Türöffnung. Die Gegenstation 17 dient als Ladestation für die Sensoreinrichtung, wenn die Tür im geschlossenen Zustand ist, sowie als drahtloser Empfänger für Messsignale der Sensoreinrichtung im geschlossenen und geöffneten Zustand der Tür.

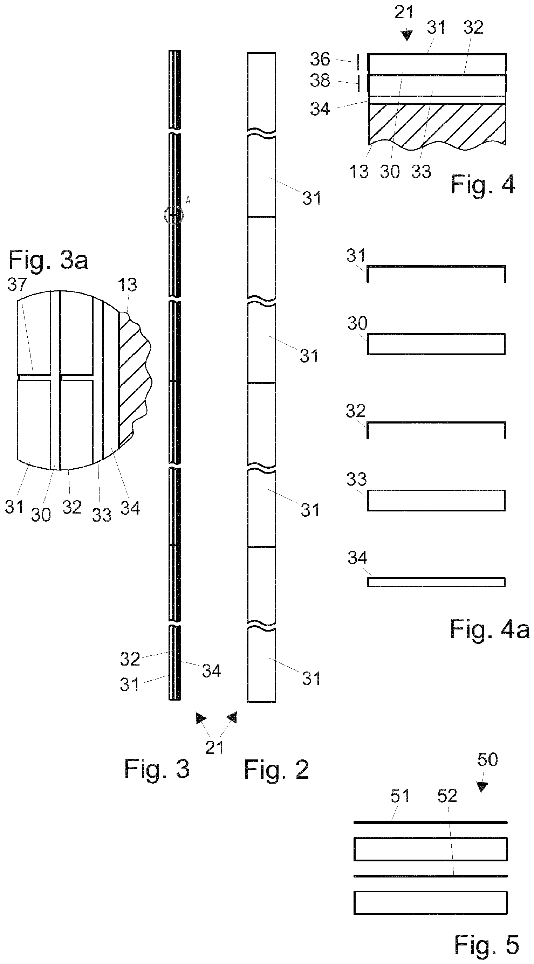

Wie in Fig. 2 ersichtlich ist, die eine Frontalansicht der Türkante 19 zeigt, weist die Sensoreinrichtung 21 eine Anzahl von Sensorelektroden 31 auf, die nebeneinander angeordnet sind, vorzugsweise übereinander und/ oder nebeneinander, auch in übereinander angeordneten Paaren oder Gruppen nebeneinanderliegender Elektroden. Die Anzahl der Sensorelektroden ist zumindest zwei, günstiger Weise mehr als zwei, z.B. drei, vier oder mehr. Eine gerade Anzahl - z.B. vier, sechs oder acht - kann günstig sein, weil dies eine paarweise Verschaltung der Sensorelektroden gestattet.

Anhand der Fig. 3, 3a, 4 und 4a ist der Aufbau der Sensoreinrichtung 21 erkennbar, der im gezeigten Ausführungsbeispiel einen Schichtaufbau verwirklicht. Die Sensorelektroden 31 sind auf einem Tragkörper 30 aufgebracht, der hier zugleich eine Isolierschicht, z.B. aus Polyäthylen, für die Sensorelektroden darstellt und die Sensorelektroden gegenüber dem Körper 13 des Türblatts isoliert. Die Sensorelektroden 31 sind beispielsweise als dünne Folien ausgebildet, mit einer Dicke von wenigen Zehntelmillimetern, z.B. 0,018 bis 0,5 mm, oder aus Blech bis zu einer Stärke von 2mm. Die Sensorelektroden 31 sind voneinander beabstandet und nebeneinander und/oder übereinander an der Türkante 19, genauer gesagt auf ihrem gemeinsamen Tragkörper 30 angeordnet, sodass zwischen je zwei Sensorelektroden 31 ein Spalt 37 ausgebildet ist.

Bezugnehmend auf Fig. 4 können die Sensorelektroden 31 über ihre stirnseitige Hauptfläche hinaus seitlich über die Ränder der Stirnfläche hinausragen und einen schmalen Randbereich 36 der Türfläche bedecken. Sie weisen somit eine L- oder U-Form auf, je nachdem, ob sie auf einer oder beiden Seiten der Türfläche einen anschließenden Randbereich 36 aufweisen. Die Sensorelektroden 31 weisen zudem (nicht gezeigte) Kontaktstellen auf, über welche die Sensorelektroden in herkömmlicher Weise an elektrische Leitungen angeschlossen sind, die durch das Innere des Tragkörpers 30 und an z.B. der Oberseite der Sensoreinrichtung zur Verbindung mit der Steuerungseinheit 22 herausgeführt sind.

Im Tragkörper 30 können gegebenenfalls auch elektronische Komponenten untergebracht sein, beispielsweise können im Falle einer kabellosen Verbindung zur Steuerungseinheit 22 im Tragkörper Messeinrichtungen vorgesehen sein, die die Kapazitätswerte messen und daraus abgeleitete Signale drahtlos an die Steuerungseinheit senden. Bei einer drahtgebundenen Verbindung kann die Messung der Kapazitäten in Messeinrichtungen im Türblatt oder direkt in der Steuerungseinheit 22 erfolgen.

Die Sensoreinrichtung gemäß der Erfindung kann zudem eine oder mehrere Schirmelektroden 32 umfassen. Die Schirmelektroden 32 sind zwischen den Sensorelektroden 31 und dem Türkörper 13 angeordnet und dienen der kapazitiven Entkopplung zwischen den Sensorelektroden und dem Potential des Türkörpers 13, das normaler Weise dem Massepotential entspricht. Im gezeigten Ausführungsbeispiel sind die Schirmelektroden 32 derart ausgebildet, dass sie in Anzahl und flächenmäßiger Aufteilung den Sensorelektroden 31 entsprechen. In anderen Ausführungsbeispielen können für die Sensorelektroden gemeinsame Schirmelektroden vorgesehen sein, insbesondere kann eine einzige gemeinsame Schirmelektrode ausgeführt sein.

Die Schirmelektroden 32 können beispielsweise als dünne Folien ausgebildet sein, mit einer Dicke von wenigen Zehntelmillimetern, z.B. 0,018 bis 0,5, mm, oder aus Blech bis zu einer Stärke von 2mm. Die Schirmelektroden 32 sind auf einem zweiten Tragkörper 33 aufgebracht, z.B. ebenfalls aus Polyäthylen, der zugleich als Isolationsschicht gegenüber dem Türblattkörper 13 dient. Die einzelnen Schirmelektroden 32 sind im gezeigten Ausführungsbeispiel voneinander beabstandet und - in einer den Sensorelektroden 31 entsprechenden Art - nebeneinander bzw. übereinander auf ihrem gemeinsamen Tragkörper 33 angeordnet. Auf den Schirmelektroden 32 wiederum befindet sich der oben erwähnte Tragkörper 30 der Sensorelektroden. Der Tragkörper 33 der Schirmelektroden ist mithilfe eines Trägerelements 34 auf dem Körper 13 des Türblatts auf dessen Stirnseite angebracht. Das Trägerelement 34 dient der mechanischen Anpassung zwischen Sensoreinrichtung 21 und Türblattkörper 13 und ist beispielsweise als ein rechteckig-streifenförmiges Bauteil aus einem elektrisch isolierenden, mechanisch festen Kunststoffmaterial. In vereinfachten Ausführungen kann der Tragkörper 33 direkt mit dem Türblattkörper 13 verbunden sein bzw. selbst zugleich als Trägerelement für den Türblattkörper 13 dienen.

Die Verbindung zwischen den Komponenten/Schichten erfolgt im gezeigten Ausführungsbeispiel durch Klebung, kann in anderen Varianten jedoch durch jegliche andere geeignete Verbindungsweise, wie Verschrauben, Nieten, Verkleben, Klammern, Haltebänder oder -folien usw. erreicht werden.

Die Schirmelektroden 32 können in elektrischer Hinsicht günstiger Weise gesteuerte Schirmelektroden sein, die jeweils mit der gleichen Wechselspannung gespeist werden wie die kapazitiven Sensorelektroden. Die Schirmelektroden 32 sind beispielsweise über (nicht gezeigte) Kontaktstellen und elektrische Leitungen, die durch das Innere des Tragkörpers 33 z.B. an die Oberseite der Sensoreinrichtung herausgeführt sind, mit der Steuerungseinheit 22 verbunden.

Die Schirmelektroden 32 trennen die Sensorelektroden 31 und das Türblatt 13 räumlich und somit auch elektrisch. Die Form der Schirmelektrode(n) 32 kann beispielsweise derart sein, dass sie über ihre stirnseitig orientierte Hauptfläche hinaus seitlich hinausragen und einen schmalen Randbereich 38 der Türfläche bedecken, sodass sie eine L- oder U-Form aufweisen, je nachdem, ob sie auf einer oder beiden Randkanten über den Rand verlaufen.

In anderen Ausführungsvarianten kann eine Schirmelektrode die zugehörende(n) kapazitive(n) Sensorelektrode(n) auch zum Teil umfassen, beispielsweise rinnen- oder becherartig. Zusätzlich kann die Schirmelektrode mit seitlich vor- oder abstehenden Ansätzen versehen sein.

Seitens der Steuerungseinheit werden laufend, d.h. mehrmals in der Sekunde, vorzugsweise 50mal bis 250mal pro Sekunde, die Werte der Kapazitäten jeder einzelnen Sensorelektrode 31 gegen Erde und untereinander, sowie gegebenenfalls die Kapazitätsänderung zwischen den einzelnen Sensorelektroden 31 und der zugehörenden Schirmelektrode(n) 32 ermittelt. Hierzu sind Messeinrichtungen zur Bestimmung der Kapazität nach an sich bekannter Art in der Sensoreinrichtung 21 und/ oder der Steuerungseinheit 22 vorgesehen. Ein vor der Sensoreinrichtung 21 befindliches Hindernis bewirkt eine in der Regel sehr große Kapazitätsänderung der Sensorelektroden in Bezug auf Massepotential, jedoch eine sehr kleine oder keine in Bezug auf die Schirmelektroden, wogegen Wasser auf einer Sensorelektrode eine starke Kapazitätsänderung der Sensorelektroden gegen die Schirmelektroden bewirkt. Ein vor der Sensorelektrode befindliches Hindernis bewirkt eine große Kapazitätsänderung zwischen Sensorelektrode und Erde, und zwar in eine der durch Wasser hervorgerufenen Kapazitätsänderung zwischen Sensorelektroden und Schirm entgegengesetzte Richtung, wodurch ein Hindernis auch dann gut erkannt werden kann, wenn die Sensorelektroden mit Wasser benetzt sind. Die Änderung durch Wasser kann somit an ihrer Richtung erkannt werden, um eine Wertung als Hindernis auszuschließen.

Da sich die Sensorelektroden 31 über eine beträchtliche Länge erstrecken und dadurch, dass erfindungsgemäß zumindest zwei Sensorelektroden 31 für eine Vergleichsmessung ihrer Potentiale herangezogen werden, kann eine gleichsinnige Potentialänderung an zwei Sensorelektroden als Auslöser der Generierung eines Haltesignals für den Motor der motorisierten Schiebetür außer Acht gelassen werden. Das Generieren eines Signals zum Anhalten des Motors kann nur dann erfolgen, wenn sich tatsächlich eine Person im Bereich der Sensorelektroden 31 befindet und daher eine unterschiedliche Potentialänderung in den relevanten Sensorelektroden 31 hervorruft. Auf diese Weise ist das System als weitgehend unempfindlich gegenüber Beeinträchtigungen wie Feuchtigkeit oder Schmutz anzusehen.

Beispielsweise kann die Sensoreinrichtung der Fig. 2-4 folgende Maße aufweisen: Ausgehend von einer Türdicke von z.B. 50 mm (= Breite der Türstirnfläche) haben die Tragkörper 30, 33 dieselbe Breite, sowie eine Länge, die insgesamt der Höhe des Türblatts entspricht, z.B. 2085 mm. Bei einer Ausführungsform mit vier Sensorelektroden zu 0,3 mm haben diese eine Größe von 50,6 mm x 520 mm, mit einer Breite des Spaltes 37 von 1 mm. Bei höheren oder weniger hohen Türblättern können die Höhen aller oder einzelnen Sensorelektroden geeignet variiert werden. Die Dicke der Tragkörper 30, 33 ist z.B. 7,5 mm, wovon je 6 mm von den seitlichen Erweiterungen der Elektroden bedeckt sind.

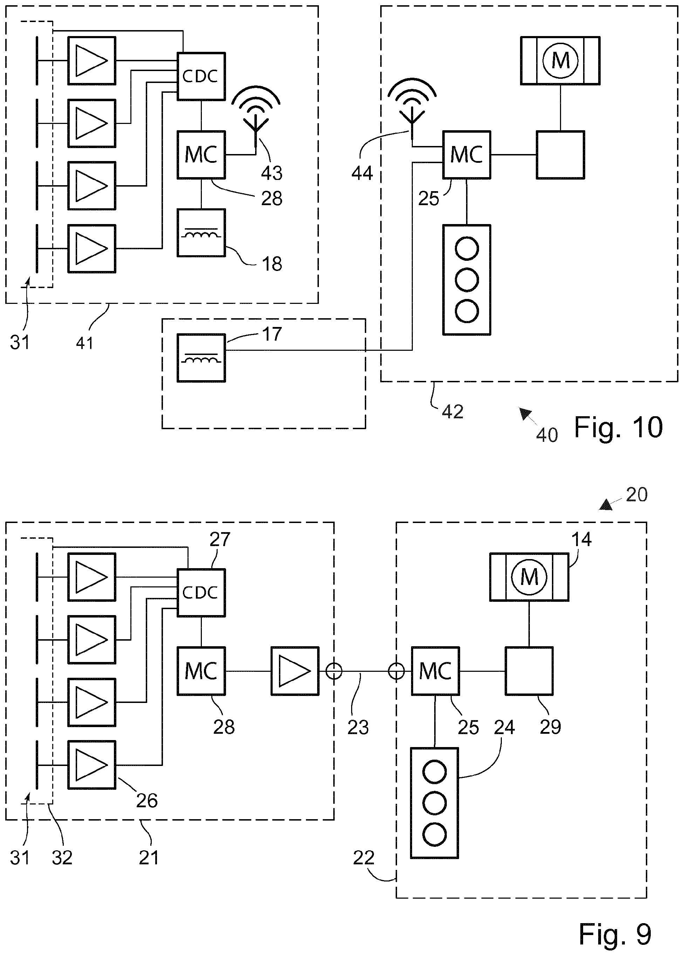

Fig. 9 zeigt ein schematisches Schaltbild in Blockdiagrammform des Steuersystems 20. Die in der Sensoreinrichtung 21 auf dem Türblatt 12 angeordneten kapazitiven Sensorelektroden 31 sind im linken Bereich der Figur durch vertikale Linien symbolisiert und wirken gegenüber Massenpotential (nicht gezeigt). Die Schirmung durch die Schirmelektrode 32 ist im Schaltbild durch eine Strichlinie angedeutet. Die Sensoreinrichtung 21 bzw. die Sensorelektroden 31 ist/ sind wie erwähnt über elektrische Leitungen 23 an die Steuerungseinheit 22 angeschlossen. Die Steuerungseinheit 22 beinhaltet eine zentrale Recheneinheit 25, die z.B. als Mikrocontroller (MC) ausgeführt ist und von der Sensoreinrichtung 21 empfangene Signale entgegennimmt, diese gemäß Befehlen, die vom Benutzer über das Bedienpaneel 24 eingebbar sind, verarbeitet und demgemäß den Motor 14 der Tür (beispielsweise über Leistungsverstärker 29) ansteuert, um die Tür zu öffnen und zu schließen. Zur Überwachung der Bewegung der Tür, insbesondere einer schließenden Bewegung, werden die Signale der Sensorelektroden 31 über Verstärker 26 und Wandler 27 zur Konversion der gemessenen Kapazitäten zu Digitalsignalen (CDC, für "Capacitance to Digital Converter") einem Mikrocontroller (MC) 28 der Sensoreinrichtung zugeführt und verrechnet. Die so ermittelten Kapazitätswerte werden (gegebenenfalls mithilfe von Treibern) über die Leitungen 23 an die Recheneinheit 25 der Steuerungseinheit 22 geleitet. Die zentrale Recheneinheit 26 kann so laufend die Messwerte der Sensorelektroden 31 überwachen. Wenn hier eine Änderung der Kapazitäten bzw. einer Kapazitätsdifferenz über einen Schwellwert ermittelt wird, wird eine Schließbewegung des Motors 14 blockiert; gegebenenfalls kann auch eine Rückbewegung eingeleitet werden, beispielsweise um einen vorprogrammierten Rücklaufweg von wenigen mm. Der Schwellwert hängt von den örtlichen Gegebenheiten ab und wird linear nach dem Verhältnis der unmittelbar nach der Montage gemessenen örtlichen Störungen zu einer für jeden Tortyp auf der Basis von Typ-Messungen festgelegten Größe eingestellt und in der Recheneinheit dauerhaft programmiert. Das Steuersystem 20 kann auch weitere Sensoren umfassen, die z.B. den Schließzustand der Tür oder andere Parameter kontrollieren, diese stellen jedoch nicht den Gegenstand dieser Erfindung dar.

Ein Beispiel für eine kabellose Variante des Steuersystems 40 ist in Fig. 10 gezeigt. In diesem Fall erfolgt der Informationsaustausch zwischen der Sensoreinrichtung 41 und der Steuerungseinheit 42 über eine Funkverbindung, die in Fig. 10 durch Antennen 43, 44 symbolisiert ist. Die Sensoren 31 sind in gleicher Art wie zu der vorhergehenden Ausführungsform der Fig. 9 beschrieben mit dem Mikrocontroller 28 der Sensoreinrichtung 41 verbunden, von wo die so ermittelten Werte der Kapazitäten und/oder Kapazitätsdifferenzen über die Funkverbindung an die Steuerungseinheit 42 gesendet werden; wo die weitere Verarbeitung der Messwerte nach der zu Fig. 9 beschriebenen Art erfolgt. Eine Leistungsversorgung 18, die mit einer Gegenstation 17 in der Rahmenkonstruktion 11 zusammenarbeitet, dient der Energieversorgung der elektrischen Komponenten der Sensoreinrichtung 41. Die Leistungsversorgung 18 und die zugehörende Gegenstation 17 sind beispielsweise im Bereich der oberen Ecke der Türöffnung 16 angebracht und kommen bei geschlossener Tür miteinander in induktiven oder galvanischen Kontakt, sodass im geschlossenen Zustand ein in der Leistungsversorgung 18 enthaltener Energiespeicher aufgeladen werden kann; auf diese Weise ist ein Betrieb auch im geöffneten und teilgeöffneten Zustand gewährleistet.

Zusätzlich kann, insbesondere im Fall eines kabellosen Steuersystems 40, vorgesehen sein, dass die Gegenstation 17 zu Beginn und am Ende jeder Türbewegung ein Signal an die Sensoreinrichtung 41 sendet, beispielsweise in Form eines Funksignals oder Infrarot-Signals. Seitens der Leistungsversorgung 18 wird dieses Signal empfangen; im Falle eines Infrarot-Signals kann die Leistungsversorgung 18 z.B. eine Photozelle aufweisen, mit der aus dem Signal zugleich die elektrische Energie gewonnen wird. Die drahtlos (z.B. mittels Infrarot oder Funksignal) übertragene Energie kann dazu verwendet werden, die Elektronik der Sensoreinrichtung 41, insbesondere deren kabellosen Übertragungsteil, "aufzuwecken" und zu betreiben. Zum Ende bzw. nach der Türbewegung wird die Sensoreinrichtung wieder deaktiviert, sodass sie ruht und möglichst wenig oder gar keine Energie verbraucht. Somit verbraucht die Sensorelektronik, insbesondere deren kabelloser Übertragungsteil, nur wenig Energie, während die Türe offen steht; der Energiespeicher bleibt geladen und ist für die nächste Bewegung verfügbar, selbst wenn diese erst nach einiger Zeit erfolgt, z. B. nach Tagen oder Wochen.

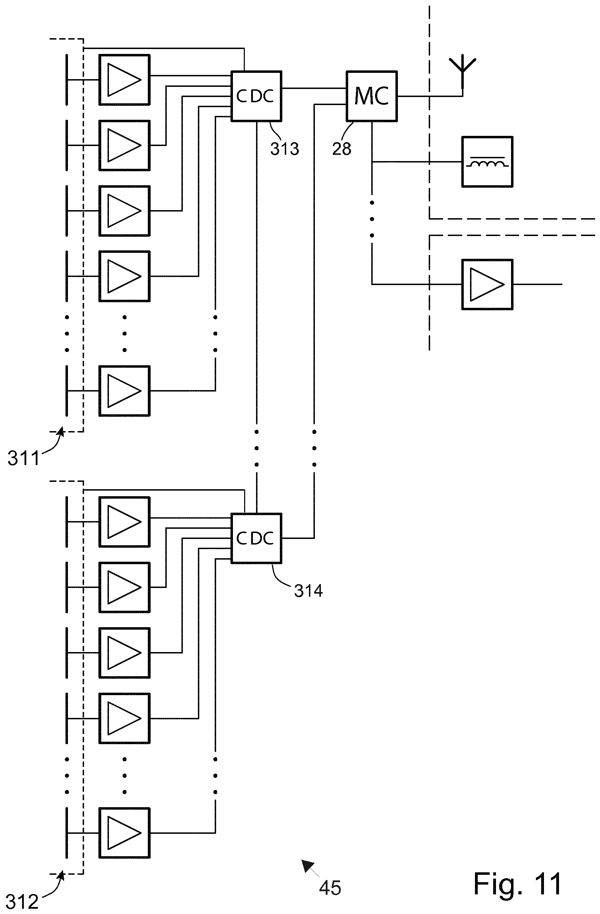

Fig. 11 zeigt ein Schaltbild einer Variante 45 der Sensoreinrichtung mit mehreren Gruppen 311, 312 von Sensorelektroden, deren Messsignale jeweils in einem eigenen CDC 313, 314 jeder Elektrodengruppe verrechnet und von dort dem Mikrocontroller 28 zugeleitet werden, der diese wie bereits beschrieben drahtlos oder über elektrische Leitungen an die Steuerungseinheit 22 weiterleitet.

Die explodierte Aufsicht der Fig. 5 illustriert eine Variante 50 der Sensoreinrichtung, in der die Sensor- und Schirmelektroden 51, 52 als flächenartige ebene Elemente ohne seitliche Fortsätze nach vorne oder hinten ausgebildet sind. Diese Ausführung vereinfacht die Produktion der Sensoreinrichtung, bei gegebenenfalls höherer Anfälligkeit gegenüber Störungen wie Streukapazitäten.

Die Anzahl und die Bemaßung der Sensor- und Schirmelektroden können variieren und können je nach der gebotenen Anwendung angepasst werden. Beispielsweise können die Elektroden wie gezeigt längliche Rechtecke mit geeignet gewähltem Seitenverhältnis, aber auch quadratisch, oder aus mehreren Quadraten zusammengesetzt sein. Die Flächen der Sensor- und Schirmelektroden können die gesamte Stirnfläche des Türblatts bedecken oder nur einen Teilbereich desselben bzw. nur einen Teil von dessen Breite.

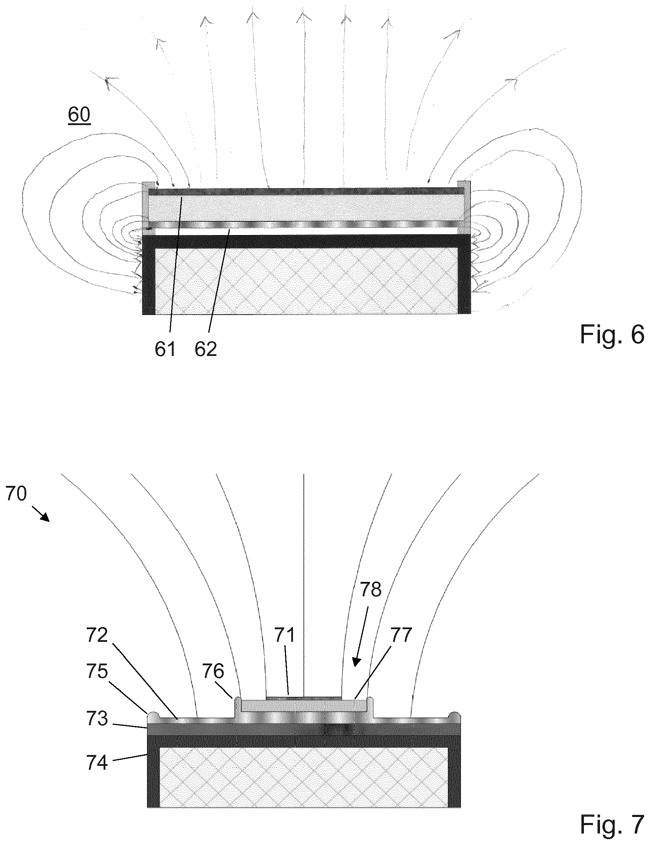

In der Schnittansicht der Fig. 6 (Schnitt entlang der Horizontalen) sind am Beispiel einer weiteren Ausführungsvariante die Feldlinien 60 sowohl der Sensorelektrode 61 als auch der Schirmelektrode 62 dargestellt. Es ist zu erkennen, dass die Feldlinien, die von den kapazitiven Schirmelektroden 62 ausgehen, zu einer Abschirmung der Feldlinien führen, die von den Sensorelektroden 61 ausgehen. Dadurch wird das kapazitive Feld der Sensorelektroden 61 deutlich weniger empfindlich gegenüber Störungen, die für die Sicherheit der Überwachung der Schließbewegung der motorisierten Schiebetür irrelevant sind.

Fig. 7 zeigt eine Schnittansicht einer weiteren Ausführungsform 70 der Erfindung, bei der die Schirmelektrode 72 als Leisten oder Vorsprünge ausgebildete Trennelemente 75, 76 aufweist, die zur besseren elektrischen und elektromechanischen Abgrenzung der mittig angebrachten Sensorelektrode 71 dient. Die Sensorelektrode 71 ist auf einem elektrisch isolierenden Trägermaterial 77 innerhalb einer nutenartigen Struktur 78 angeordnet, die von zwei Leisten 75 der Schirmelektrode 72 gebildet ist, die das Trägermaterial 77 beiderseits umgeben. Auch in diesem Ausführungsbeispiel ist die Schirmelektrode 72 durch eine Isolatorschicht 73 von dem Körper 74 des Türblatts elektrisch getrennt. Die Schirmelektrode 72 weist in ihrem mittleren Bereich - der einem vertikal verlaufenden Mittelstreifen auf der Stirnfläche des Türblatts entspricht - die erwähnte Struktur 78 auf.

Die beiden Ränder der Schirmelektrode sind bevorzugt als vorspringende Leisten 76 ausgebildet. In ähnlicher Weise bilden die Leisten 75 einerseits vorzugsweise einen Absatz mit den Außenflächen der Schirmelektrode 72; andererseits ragen die Leisten 75 bevorzugt über die Oberfläche des Trägermaterials 77 hervor. Die Leisten 75, 76 bilden auf diese Weise Strukturen, die einen allfälligen Wasser- oder Schmutzfilm unterbrechen, die sonst elektrische Brücken zwischen den Elektroden und/oder dem Türblatt bilden können. Beispielsweise kann der Fall eintreten, dass sich ein Wassertropfen (oder Wasser- oder Schmutzfilm) auf der Stirnseite des Türblatts befindet und hierbei über den Rand der Sensorelektrode 75 bis zur Schirmelektrode 76 reicht, was zu Kurzschließen der Sensor- und Schirmelektroden 71, 72 führen würde. Die Leiste 75 teilt den Tropfen (oder Film) und wirkt so als Trennelement, das die verschmutzungsbedingte elektrische Verbindung zwischen den Elektroden unterbricht. In ähnlicher Weise unterbricht die Leiste 76 eine durch Wasser oder Schmutz auftretende Verbindung zwischen der Schirmelektrode 72 und dem Türblattkörper 74. Auf diese Weise wird die Störanfälligkeit gegenüber Spritzwasser, Regen u.dgl. deutlich verringert.

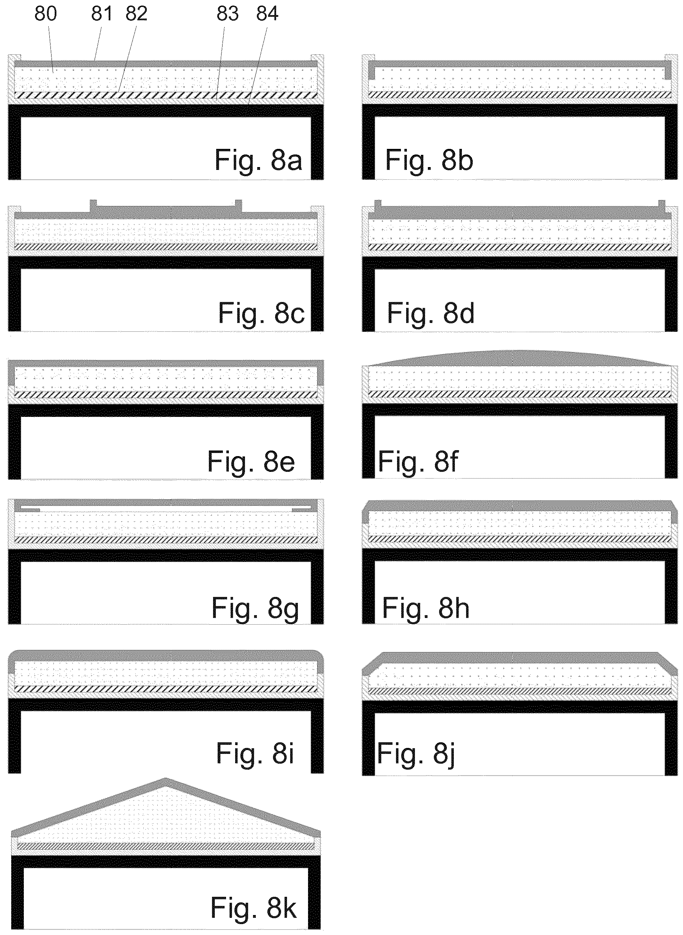

In den Fig. 8a bis 8k sind weitere Ausführungsbeispiele der Ausgestaltung der Sensor- und Schirmelektroden dargestellt, jeweils in einer Schnittansicht entlang der Horizontalen. Hierbei entspricht Fig. 8a der Ausgestaltung der Fig. 6. In diesen Figuren sind die Komponenten durch jeweils gleiche Schraffuren dargestellt. Die Ausführungsbeispiele der Fig. 8a-8k unterscheiden sich in erster Linie durch die Formgebung der Sensorelektrode 81, während die Schirmelektrode 82 bevorzugt als planare Schicht ausgeführt sein kann, allerdings gegebenenfalls auch andere (nicht gezeigte) Formgebung haben kann. Die Trägerschicht 80 und das Trägerbauteil 83 dienen der elektrische Isolierung sowie der mechanischen Stabilisierung der Elektroden. Die Verbindungsschicht 83 dient zudem der Anbringung der Sensoreinrichtung am Türblattkörper 84 sowie als seitliche Abgrenzung.

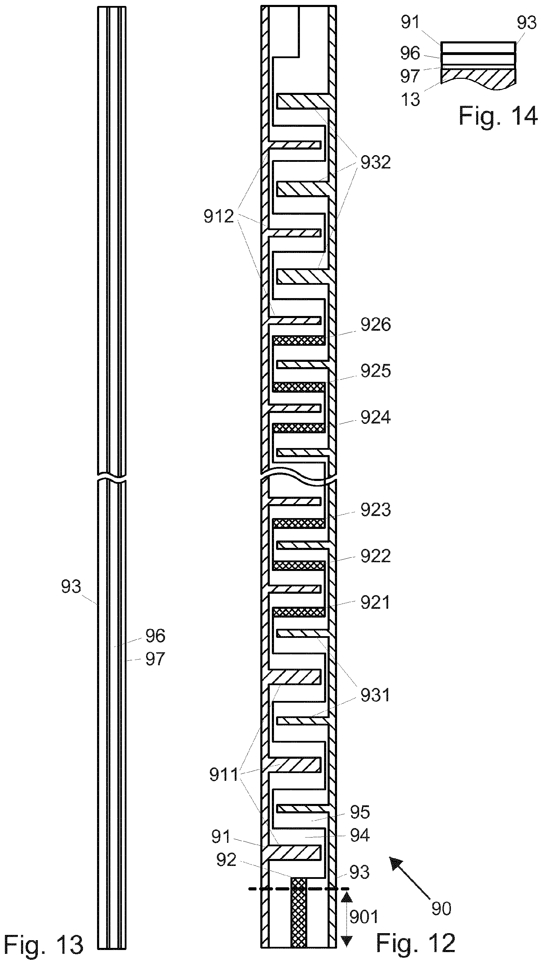

In Fig. 12 bis 14 ist noch eine Ausführungsform einer Sensoreinrichtung 90 dargestellt, in der durch eine vorteilhafte geometrische Aufteilung der Frontfläche für die Sensorelektroden eine besondere Störunempfindlichkeit gegenüber äußere elektromagnetische Einflüsse erreicht wird. Durch eine Formgebung der Sensorelektroden mit zueinander unterschiedlichen Formen kann die Empfindlichkeit gegenüber äußeren Störungen deutlich verringert werden.

Die Sensoreinrichtung 90 beinhaltet beispielsweise drei Sensorelektroden 91, 92, 93, die alle drei sich über die ganze Höhe der Türkante erstrecken und im Wesentlichen nebeneinander verlaufende Streifen mit variabler Breite und/ oder mit Elektrodenflächen auf verschiedenen Höhen der Türkante bilden. Auf diese Weise können die Einstrahlungen von Störeinflüssen aufgrund der Eigenschaft der Elektroden als Antennen besser kompensiert werden, sodass die Sensoreinrichtung 90 insgesamt weniger störanfällig für externe Einstrahlungen ist. Hierbei dienen die beiden äußeren Elektroden 91, 93 (links bzw. rechts) insbesondere dazu, von den Seiten kommende Hindernisse zu detektieren. Um auch ein solches Hindernis, das sich genau mittig vor der Sensoreinrichtung 90 befindet, insbesondere wenn es sich nicht über die gesamte Länge der Türkante erstreckt, zu detektieren, ist es günstig, wenn die seitlichen Sensorelektroden 91, 93 der Länge nach unsymmetrisch ausgebildet sind und/ oder mit wenigstens einer dazwischen angeordneten Sensorelektrode 92, die ebenfalls der Länge nach unsymmetrisch ausgebildet ist, ergänzt werden. Damit wird erreicht, dass die Sensorelektroden 91, 92, 93 einerseits zueinander gleiche Kapazität haben, andererseits diese Kapazitäten über die Länge der Sensoren unterschiedlich verteilt sind. Es kommt daher zu insgesamt gleichartigen Feldbereichen der Elektroden, die aber in den einzelnen Abschnitten der Sensoreinrichtung unterschiedlich sind und bei Störung durch ein Hindernis unterschiedlich ansprechen und so ein messbares Signal liefern. Auf diese Weise können in jeder Position, seitlich oder auch direkt vor der Sensoreinrichtung, kleinste Hindernisse ebenso gut wie größere erkannt werden.

Zwischen den Sensorelektroden 91, 92, 93 können freie Bereiche 94, 95 verbleiben, in denen das Trägermaterial der Elektroden unbedeckt ist oder die darunter liegende Schirmelektrode 96 sichtbar wird. Die Sensorelektroden 91, 92, 93 können kammartig und/oder mäanderartig ausgeführt sein, um eine Aufteilung in mehrere Teilflächen zu erreichen, die vorzugsweise jeweils in verschiedenen Bereichen der Türkante (d.h. auf verschiedenen Höhenbereichen) angeordnet sind. Beispielsweise umfasst die erste Sensorelektrode 91 mehrere Elektrodenflächen 911, 912, wobei die (z.B. drei) Elektrodenflächen 911 in einem unteren Bereich der Türkante beispielsweise breiter sind als die anderen Elektrodenflächen 912; die dritte Sensorelektrode 93 umfasst dem entsprechend mehrere Elektrodenflächen 931, 932, wobei die (z.B. drei) Elektrodenflächen 932 in einem oberen Bereich der Türkante beispielsweise breiter sind als die anderen Elektrodenflächen 931. Die äußeren Sensorelektroden 91, 93 sind auf diese Weise mit zueinander zeigenden Streifen 911,912, 931,932 ausgerüstet, die jeweils gleiche Breite haben bzw. (wie in Fig. 12 gezeigt) unterschiedliche Breiten aufweisen können. Zwischen den äußeren Elektroden 91, 93 ist (zumindest) eine mittlere Elektrode 92 vorgesehen, die vorzugsweise mäanderförmig verläuft und beispielsweise in einem mittleren Bereich der Türkante mehrere Elektrodenflächen 921, 922, 923, ... 924, 925, 926 umfasst. Zwischen den Elektrodenflächen haben die Sensorelektroden eine geringere Breite, bevorzugt sind sie schmal, d.h. die Breite ist vernachlässigbar.

Bezugnehmend auf Fig. 13 und 14 hat die Sensoreinrichtung 90 einen Schichtaufbau analog zu jenem, der weiter oben anhand der Fig. 3 und 4 beschrieben worden ist. Insbesondere kann unter den Sensorelektroden 91, 92, 93 gemeinsam auf einem Tragkörper aufgebracht und über einer gemeinsamen Schirmelektrode 96 angeordnet, deren Tragkörper wiederum mithilfe eines Trägerelements 97 auf dem Körper 13 des Türblatts angebracht ist. In Fig. 13 ist anhand des Beispiels der dritten Sensorelektrode 93 zudem erkennbar, dass auch hier die Sensorelektroden über ihre stirnseitige Hauptfläche hinaus seitlich über die Ränder der Stirnfläche hinausragen und einen schmalen Randbereich der Türfläche bedecken können.

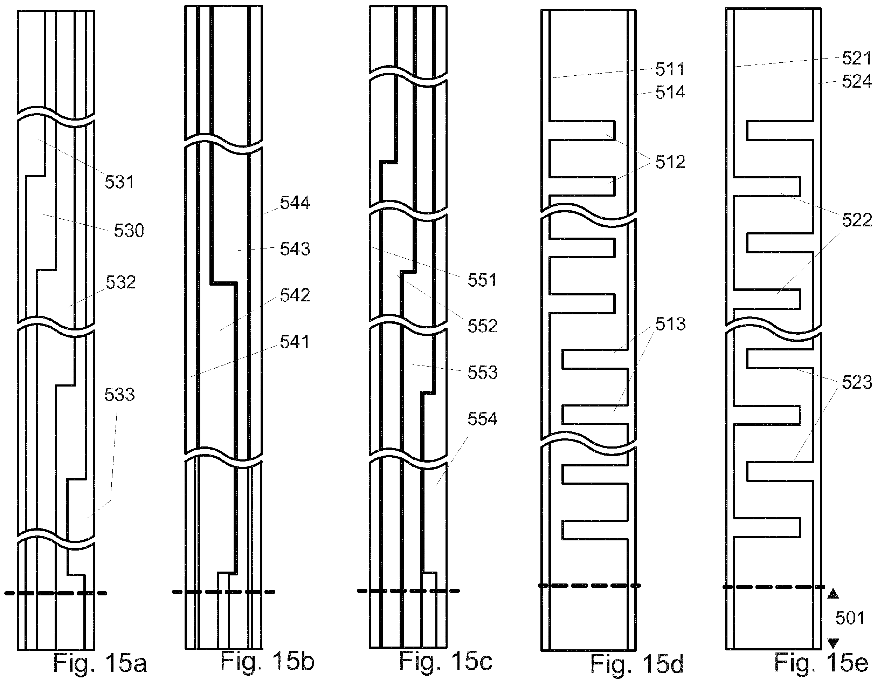

In Fig. 15a bis 15e sind weitere beispielhafte geometrische Ausgestaltungen der Sensorelektroden gezeigt.

Fig. 15a zeigt eine Ausführung mit drei streifenförmigen, der Länge nach unsymmetrischen, insgesamt aber gleichflächigen Sensorelektroden 531, 532, 533. Fig. 15b zeigt eine Ausführung mit vier Sensorelektroden 541, 542, 543, 544, wobei die beiden äußeren Elektroden 541, 544 gleichbleibende Breite aufweisen; die Elektroden 541 und 544 bzw. 542 und 543 weisen jeweils gleiches Flächenmaß auf. Fig. 15c zeigt eine weitere Ausführung mit vier Sensorelektroden 551-554, wobei hier die Elektroden gleiche Flächen aufweisen.

Zwischen den Sensorelektroden können breite unbelegte Bereiche 530 verbleiben (Fig. 15a), deren Fläche z.B. im Wesentlichen denen der Elektroden entspricht, oder die Elektroden können durch lediglich schmale Spalte getrennt sein (Fig. 15b, 15c).

Fig. 15d und Fig. 15e zeigen zwei weitere Gestaltungen von (äußeren) Sensorelektroden 511, 514, 521, 524, die jeweils mehrere Teilelektrodenflächen 512, 513, 522, 523 in Form zueinander gerichteter Streifen aufweisen, wodurch sie der Länge nach unsymmetrisch sind. In Fig. 15d sind die Teilflächen 512, 513 in Gruppen angeordnet, die in verschiedenen Höhenbereichen entsprechen, während in Fig. 15e die Teilflächen 522, 523 kammartig ineinandergreifen. Aufgrund dieser Aufteilung der Teilflächen der Sensorelektroden erfassen die Sensorelektrode einen ungleichmäßigeren Feldbereich, der von kleinen Hindernissen stärker beeinflusst wird als dies für die Geometrien der Fig. 15a bis 15c der Fall ist. Zwischen den äußeren Sensorelektroden 511 und 514 bzw. 521 und 524 können gegebenenfalls (nicht gezeigt) ein oder mehrere mittlere Sensorelektroden vorgesehen sein.

Weiters können die Sensoren der in Fig. 12-15e illustrierten Typen auch durch Kürzen bis zu (maximal) den strichlierten Linien an Tore angepasst werden, weil die im Endbereich 901, 501 unterhalb dieser strichlierten Linien liegenden Gebiete der Sensorelektroden gleich groß sind und ein Kürzen die Kapazitätsverhältnisse der Sensoren untereinander nicht (oder nur unwesentlich) verändert. Der maximale Kürzungsbetrag am unteren Ende entspricht hier der Höhe des Endbereichs 901, 501. Dieses Kürzen kann je nach Ausgestaltung der Sensoreinrichtung an dem unteren Endbereich 901, 501 und/ oder dem oberen Endbereich vorgesehen sein.

Selbstverständlich ist die Erfindung nicht auf die hier gezeigten Ausführungsformen eingeschränkt und es sind noch vielfältige weitere Gestaltungen im Rahmen der Erfindung möglich, sofern diese unter den Schutzbereich der nachstehenden Ansprüche fallen.

## Patentansprüche

1. Verfahren zum Steuern einer von einem Motor (14) angetriebenen Tür (10), insbesondere Schiebetür, bei welchem die Kapazitäten zumindest zweier an einer Stirnfläche eines Türblatts (12) der Tür angeordneten kapazitiven Sensorelektroden (31, 51, 61, 71, 81) unabhängig voneinander gegen ein gemeinsames Referenzpotential, vorzugsweise Massepotential, ermittelt werden und bei Feststellen einer Kapazitätsänderung an zumindest einer der Sensorelektroden (31, 51, 61, 71, 81) im Vergleich zu zumindest einer weiteren Sensorelektrode (31, 51, 61, 71, 81) ein Signal zum Anhalten des Motors generiert wird.

2. Verfahren nach Anspruch 1, **dadurch gekennzeichnet, dass** die kapazitiven Sensorelektroden (31) gegenüber dem Türblatt (19) durch zumindest eine gesteuerte Schirmelektrode räumlich und elektrisch getrennt werden.

3. Verfahren nach Anspruch 2, **dadurch gekennzeichnet, dass** die Schirmelektrode (32) mit der gleiche Phase und Amplitude wie die Sensorelektroden (31) betrieben wird, vorzugsweise durch dieselbe Quelle.

4. Verfahren nach einem der Ansprüche 1 bis 3, **dadurch gekennzeichnet, dass** aufseiten des Türblatts eine den kapazitiven Sensorelektroden zugeordnete Sensoreinrichtung (41) Signale betreffend Kapazitäten und/ oder Kapazitätsdifferenzen vorzugsweise drahtlos an eine Steuerungseinheit (42) zum Steuern des Motors übermittelt, und dass zu Beginn und am Ende einer Türbewegung der Tür (10) Steuersignale an die Sensoreinrichtung (41) gesendet werden, mithilfe welcher Steuersignale die Sensoreinrichtung (41) für die Dauer der Türbewegung aktiviert wird.

5. Steuersystem (20) zum Steuern einer von einem Motor angetriebenen Tür (10), insbesondere Schiebetür, umfassend zumindest zwei kapazitive Sensorelektroden (31, 51, 61, 71, 81), die an einer an einer Stirnfläche eines Türblatts (12) der Tür (10) vorgesehen sind, sowie eine Steuerungseinheit (22, 42), welche dazu eingerichtet ist, über die Sensorelektroden (31, 51, 61, 71, 81) unabhängig voneinander gegen ein gemeinsames Referenzpotential, vorzugsweise Massepotential, ermittelte Kapazitätsmesswerte zu vergleichen und bei Feststellen eines Kapazitätsunterschiedes an zumindest einer der Sensorelektroden (31, 51, 61, 71, 81) im Vergleich zu zumindest einer weiteren Sensorelektrode (31, 51, 61, 71, 81) ein Signal zum Anhalten des Motors zu generieren.

6. Steuersystem nach Anspruch 5, **dadurch gekennzeichnet, dass** die kapazitiven Sensorelektroden (31) von dem Türblatt (13) räumlich und elektrisch getrennt sind und zwischen Sensorelektroden (31) und dem Türblatt (13) zumindest eine gesteuerte Schirmelektrode (32) vorgesehen ist.

7. Steuersystem nach Anspruch 6, **dadurch gekennzeichnet, dass** die zumindest eine gesteuerte Schirmelektrode (32) von den Sensorelektroden (31) und dem Türblatt (13) durch eine Isolierung getrennt ist und bevorzugt eine die Sensorelektrode(n) zum Teil umfassende Formgebung aufweist.

8. Steuersystem nach Anspruch 6 oder 7, **dadurch gekennzeichnet, dass** die Schirmelektrode (72) seitlich abstehende Ansätze und/oder an ihren Rändern vorspringende Leisten (75, 76) aufweist.

9. Steuersystem nach einem der Ansprüche 5 bis 8, **dadurch gekennzeichnet, dass** die Steuerungseinheit (22) dazu eingerichtet ist, anhand der Art der Kapazitätsänderung das Vorhandensein von Wasser auf einer Sensorelektrode von einem vor den Sensorelektroden befindlichen Hindernis zu unterscheiden.

10. Steuersystem nach einem der Ansprüche 5 bis 9, **dadurch gekennzeichnet, dass** die kapazitiven Sensorelektroden (31) in einer Sensoreinrichtung (21) auf der Stirnfläche übereinander als voneinander beabstandete Streifen aus leitendem Material, vorzugsweise aus Metall, auf einer Isolierschicht (30), insbesondere auf einer Isolierschicht aus Polytetrafluoräthylen oder einem Epoxidharz mit Glasgewebe-Einlage, angeordnet sind, wobei die Sensoreinrichtung (21) ein Trägerelement (34, 83) umfasst, auf welchem die Sensorelektroden sowie gegebenenfalls die Schirmelektrode in einer vorgegebenen Anordnung positioniert sind und welches zur Befestigung auf der Stirnfläche eines Türblatts befestigbar ist.

11. Steuersystem nach einem der Ansprüche 5 bis 10, aufweisend eine seitens des Türblatts vorgesehene Sensoreinrichtung (41), die mit der Steuerungseinheit (42) über eine drahtlose Schnittstelle (17, 18) verbunden ist, über welche von der Sensoreinrichtung (41) ermittelte Werte der Kapazitäten und/oder Kapazitätsdifferenzen drahtlos übermittelt werden, wobei vorzugsweise die Energieversorgung der Sensoreinrichtung über die drahtlose Schnittstelle (17, 18) erfolgt, beispielsweise über ein Funk- oder Infrarot-Signal.

12. Steuersystem nach einem der Ansprüche 5 bis 11, **dadurch gekennzeichnet, dass** die Sensorelektroden (31) über einen oder beide der seitlichen Ränder der Stirnfläche (19) hinaus reichen, nämlich in einen jeweiligen Randbereich einer an die Stirnfläche anschließenden Türfläche.

13. Steuersystem nach einem der Ansprüche 5 bis 12, **dadurch gekennzeichnet, dass** die Sensorelektroden (91, 92, 93) über die gesamte Höhe der Stirnfläche verlaufen, wobei jede der Sensorelektroden eine entlang der Höhe und in von den anderen Sensorelektroden unterschiedlicher Weise variierende Breite aufweist.

14. Steuersystem nach einem der Ansprüche 5 bis 12, **dadurch gekennzeichnet, dass** die Sensorelektroden (91, 92, 93) über die gesamte Höhe der Stirnfläche verlaufen, wobei sich in jeder der Sensorelektroden schmale Bereiche mit vernachlässigbarer Breite mit zumindest zwei Elektrodenflächen (911, 912, 913, 921-926, 931, 932, 933) abwechseln.

15. Steuersystem nach einem der Ansprüche 5 bis 14, **dadurch gekennzeichnet, dass** an zumindest einem Endbereich (901, 501) der Stirnfläche die Sensorelektroden zueinander gleich breit sind, und ein Kürzen der Sensorelektroden ermöglicht ist.
